Europäisches Patentamt

European Patent Office

Office européen des brevets

(11) Veröffentlichungsnummer: **0 184 747**
**A1**

## (12) EUROPÄISCHE PATENTANMELDUNG

(21) Anmeldenummer: 85115259.5

(22) Anmeldetag: 02.12.85

(51) Int. Cl.⁴ **H01L 31/02**

(30) Priorität: 13.12.84 DE 8436542 U
08.08.85 DE 3528557

(43) Veröffentlichungstag der Anmeldung:
18.06.86 Patentblatt 86/25

(84) Benannte Vertragsstaaten:
DE FR GB IT

(71) Anmelder: Heimann GMBH
Weher Köppel 6
D-6200 Wiesbaden 1(DE)

(72) Erfinder: Knaup, Gerhard, Dipl.-Ing.
Schillerstrasse 13
D-6947 laudenbach(DE)
Erfinder: Ringelstein, Udo, Ing. grad.
Jahnstrasse 20
D-6223 Lorch(DE)
Erfinder: Schaaf, Norbert, Dipl.-Ing.
Heerstrasse 19A
D-6200 Wiesbaden(DE)

(74) Vertreter: Mehl, Ernst, Dipl.-Ing. et al
Postfach 22 01 76
D-8000 München 22(DE)

(54) **Infrarotdetektor.**

(57) Die Erfindung betrifft einen Infrarotdetektor mit mindestens einem Detektorelement (6). Dieses ist durch eine gedruckte Leiterplatte (12) mit weiteren Bauelementen (10, 11) verschaltet und in ein hermetisch dichtes Gehäuse mit nach unten ragenden Anschlußstiften eingeschweißt. Zur Erzielung eines ausreichenden Signales ist das Detektorelement (6) mit Abstand von dem darunterliegenden Material angeordnet.

FIG 2

EP 0 184 747 A1

Infrarotdetektor

Die Erfindung betrifft einen Infrarotdetektor mit mindestens einem in einem Gehäuse auf einer Grundplatte angeordneten Detektorelement, das auf der Grundplatte mit weiteren Bauelementen verschaltet ist, bei dem von der Grundplatte Anschlußstifte nach unten ragen.

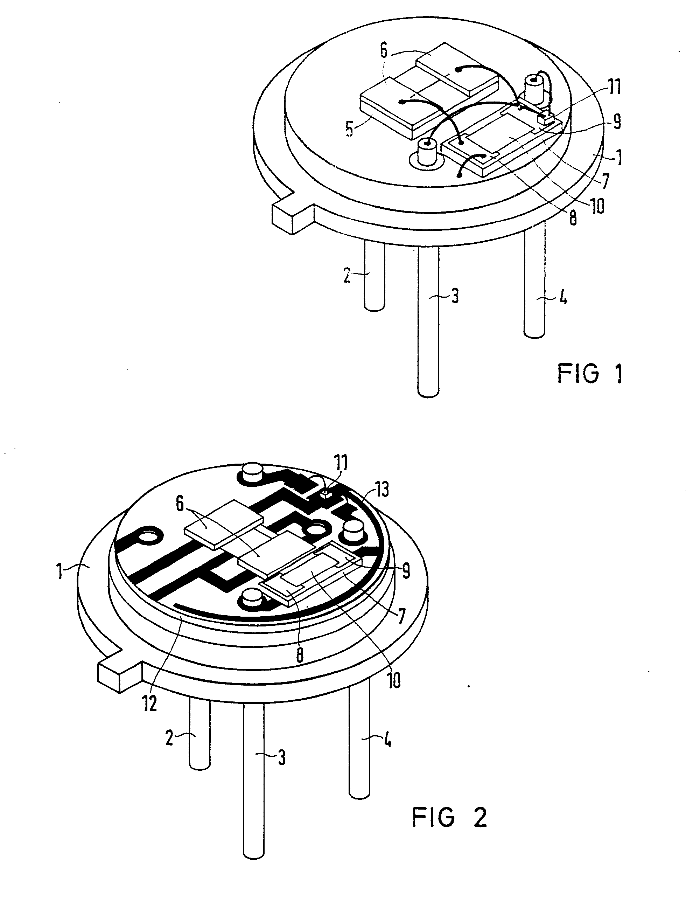

In der Figur 1 ist ein bekannter Infrarotdetektor dieser Art beschrieben. Vom Gehäuse ist dabei nur die Grundplatte 1 dargestellt, von der drei Anschlußstifte 2, 3, 4 nach unten ragen. Auf der Oberseite der Grundplatte 1 sind zwei Detektorelemente 6 für Infrarotstrahlung mit Hilfe eines Kunststoffsockels 5 befestigt. Von den Detektorelementen 6 führen Anschlußdrähte zu einer weiteren, auf der Grundplatte 1 befestigten Isolierstoffplatte 7, und zwar zu leitfähigen Bahnen 8, 9 auf dieser Isolierstoffplatte 7. Zwischen den leitfähigen Bahnen 8, 9 ist ein hochohmiger Widerstand 10 angeordnet. Ferner sitzt auf der leitfähigen Bahn 9 ein Feldeffekttransistor 11. Die Komponenten 6, 10, 11 sind in der dargestellten Weise verdrahtet und mit den Anschlußstiften 2, 3, 4 verbunden.

Die Herstellung des Infrarotdetektors gemäß Figur 1 erfolgt in der Weise, daß auf der mit den Anschlußstiften 2, 3, 4 versehenen Grundplatte 1 die einzelnen Komponenten individuell befestigt und verdrahtet werden. Anschließend wird über die Grundplatte 1 eine Kappe gestülpt, die diese Komponenten einschließt und auf ihrer Oberseite ein für die zu messende Infrarotstrahlung durchlässiges Fenster aufweist.

Der Erfindung liegt die Aufgabe zugrunde, einen Infrarotdetektor der eingangs genannten Art so auszubilden, daß die Herstellung gegenüber dem beschriebenen Stand der Technik vereinfacht ist.

Diese Aufgabe ist erfindungsgemäß dadurch gelöst, daß unmittelbar auf der Innenseite der Grundplatte eine gedruckte Leiterplatte befestigt ist, die entweder nur auf einer Seite Leiterbahnen aufweist, oder als sogenannte dual-layer-Version beidseitige Leiterbahnen besitzt, über die das Detektorelement mit weiteren Bauelementen elektrisch verbunden ist, und daß das Detektorelement mindestens in seinem mittleren Bereich einen Abstand von dem darunterliegenden Material aufweist. Bei beidseitiger Leiterbahnführung ist es selbstverständlich möglich, beide Seiten mit Bauelementen zu bestücken. Dies hat den Vorteil, umfangreiche Schaltungen (mehrstufige Vorverstärker) in einem Gehäuse unterzubringen. Bei dem erfindungsgemäßen Infrarotdetektor kann die gedruckte Leiterplatte im Vielfachnutzen zunächst mit den zugeordneten Bauelementen bestückt, vereinzelt und dann in einem Arbeitsgang auf der Grundplatte befestigt werden. Anschließend ist nur noch das Aufstülpen der Kappe auf die Grundplatte erforderlich.

Die Erfindung ist nachfolgend anhand der Figuren 2 bis 6 näher erläutert. Es zeigen:

Fig. 2 einen Infrarotdetektor nach der Erfindung mit einer einseitigen Leiterbahnführung,

Fig. 3 einen Infrarotdetektor nach der Erfindung mit einer zweiseitigen Leiterbahnführung, und

Fig. 4 bis 6 verschiedene Varianten einer Einzelheit des Infrarotdetektors gemäß den Figuren 2 und 3.

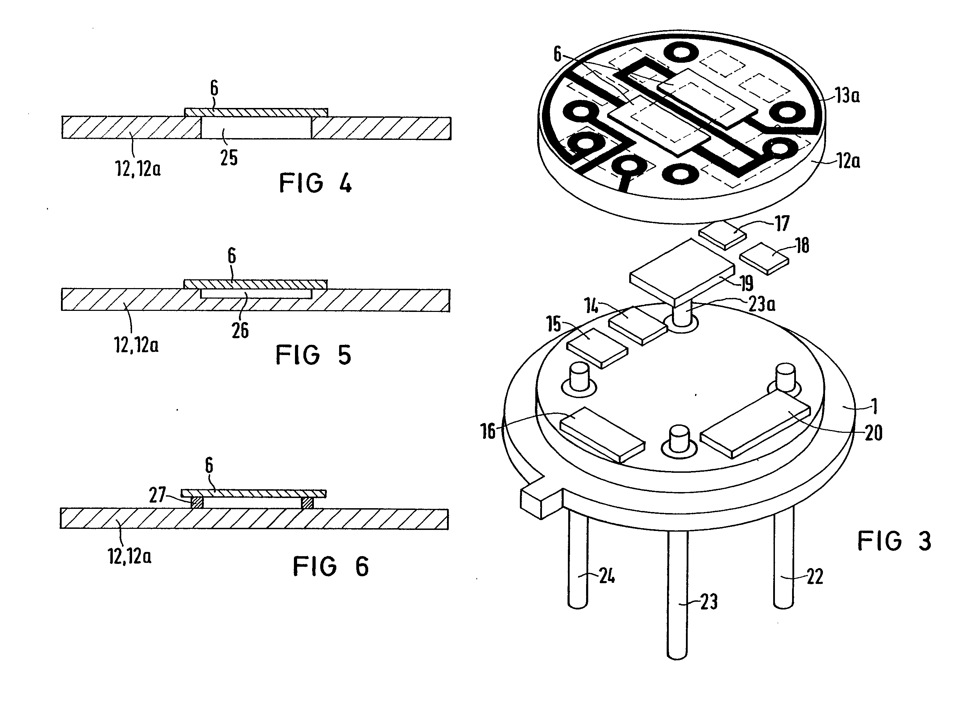

In den Figuren 2 und 3 sind Teile, die mit Teilen gemäß Figur 1 gleich sind, mit den gleichen Bezugszeichen bezeichnet. In Figur 2 sitzt auf der Grundplatte 1 eine gedruckte Leiterplatte 12, die leitfähige Bahnen 13 aufweist. Die Komponenten 6, 10 und 11 sind auf der gedruckten Leiterplatte 12 befestigt und elektrisch mit den Leiterbahnen 13 verbunden.

Die Herstellung des Infrarotdetektors kann in einfacher Weise dadurch erfolgen, daß die gedruckte Leiterplatte 12 zunächst mit den Komponenten 6, 10, 11 bestückt, vereinzelt und anschließend auf der Grundplatte 1 befestigt, z. B. festgeklebt wird. Danach ist nur noch ein Schließen durch Aufstülpen der nicht dargestellten Kappe erforderlich.

Die Ausführung der Leiterbahnen und die Komponenten, die auf der Leiterplatte angeordnet sind, hängen von der jeweils verwendeten Schaltung ab. So ist die in Figur 2 verwendete Schaltung identisch mit der Schaltung von Figur 1. Die Figur 3 zeigt den Vorschlag einer Schaltung mit doppelter Leiterbahnführung und doppelseitiger Bestückung der Bauelemente. Für diese Version kann ohne weiteres ein vierfacher Operationsverstärker z.B. auf die untere Seite bestückt werden und zahlreiche Peripherie-Bauelemente zum Teil unten, zum Teil auf der Oberseite bestückt werden, so daß die komplette Signalvorverarbeitung in einem Gehäuse untergebracht ist. Die jeweils zu verwendende Schaltung ist unabhängig von dem Einsatzfall. Je nach Art und Umfang der verwendeten Schaltung ist es selbstverständlich auch notwendig, abweichend von Figur 2, die Zahl der Anschlußstifte zu erhöhen. Die maximale Zahl der Anschlußstifte in einem TO 5-Gehäuse beträgt 12. Die Bauelemente, die durch die Leiterbahnen 13a zusammengeschaltet sind, sind in Figur 3 mit 14 bis 20 bezeichnet. Den Stiften 2, 3, 4 in Figur 2 entsprechen die Stifte 22, 23, 23a, 24 in Figur 3.

Die Figuren 4 bis 6 zeigen, daß die Detektorelemente 6, von denen in diesen Figuren nur eines dargestellt ist, mindestens mit 90 % ihrer Fläche einen Abstand von dem darunterliegenden Material aufweisen, der mindestens 0,1 mm beträgt. Dieser Abstand ist vorgesehen, damit das Signal der Detektorelemente 6 nicht reduziert wird. Man erhält durch diesen Abstand demgemäß ein Signal exakt gleicher Größe wie bei Aufbau gemäß Figur 1.

Bei den Beispielen gemäß den Figuren 4 und 5 ist der Abstand dadurch realisiert, daß die Leiterplatte 12, 12a unter dem mittleren Bereich der Detektorelemente 6 ausgespart ist. Diese Aussparung ist gemäß Figur 4 von einer durchgehenden Öffnung 25 und gemäß Figur 5 von einer Vertiefung 26 in der Leiterplatte 12 bzw. 12a gebildet.

Die Figur 6 zeigt ein Beispiel, bei dem die Detektorelemente 6 mit Abstand von der Leiterplatte 12, 12a gehalten sind. Hierzu sind zwischen den Detektorelementen 6 und der Leiterplatte 12, 12a Abstandsstücke 27 eingefügt.

Dieser notwendige Abstand von mindestens 0,1 mm ist nicht schaltungsabhängig. Der Abstand ist notwendig, um das gleiche Signal zu erreichen, das mit dem herkömmlichen Aufbau gemäß Figur 1 erzielt wird. Ansonsten erhält man eine Signalreduzierung von ca. 30 bis 50 %.

**Ansprüche**

1. Infrarotdetektor mit mindestens einem in einem Gehäuse auf einer Grundplatte (1) angeordneten Detektorelement (6), das auf der Grundplatte (1) mit weiteren Bauelementen (10, 11) verdrahtet ist, bei dem von der Grundplatte (1) Anschlußstifte (2, 3, 4, 22, 23, 23a, 24) nach unten ragen, **dadurch gekennzeichnet,** daß unmittelbar auf der Innenseite der Grundplatte (1) eine gedruckte Leiterplatte (12, 12a) befestigt ist, über die das Detektorelement (6) mit weiteren Bauelementen (10, 11) elektrisch verbunden ist, und daß das Detektorelement (6) mindestens in seinem mittleren Bereich einen Abstand von dem darunterliegenden Material (12, 12a) aufweist.

2. Infrarotdetektor nach Anspruch 1, **dadurch gekennzeichnet,** daß der Abstand mindestens 0,1 mm beträgt.

3. Infrarotdetektor nach Anspruch 1, **dadurch gekennzeichnet,** daß die Leiterplatte (12, 12a) unter dem mittleren Bereich des Detektorelementes (6) ausgespart ist.

4. Infrarotdetektor nach Anspruch 3, **dadurch gekennzeichnet,** daß die Aussparung von einer durchgehenden Öffnung (15) in der Leiterplatte (12) gebildet ist.

5. Infrarotdetektor nach Anspruch 3, **dadurch gekennzeichnet,** daß die Aussparung von einer Vertiefung (16) in der Leiterplatte (12, 12a) gebildet ist.

6. Infrarotdetektor nach Anspruch 1 oder 2, **dadurch gekennzeichnet,** daß das Detektorelement (6) mit Abstand von der Leiterplatte (12, 12a) gehalten ist.

FIG 1

FIG 2

FIG 3

FIG 4

FIG 5

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | GB-A-2 126 795 (THE PLESSEY CO. PLC)<br>* Insgesamt * | 1 | H 01 L 31/02 |
| | --- | | |
| Y | DE-A-2 140 107 (COGAR CORP.)<br>* Seite 3, Zeile 17 - Seite 5, Zeile 10; Ansprüche 1-5; Abbildungen 1-4 * | 1 | |
| A | | 4,6 | |
| | --- | | |
| A | EP-A-0 065 425 (MATSUSHITA ELECTRIC INDUSTRIAL CO., LTD.)<br>* Seite 5, Zeile 3 - Seite 7, Zeile 21; Anspruch 1; Abbildungen 1-4,9 * | 1 | |
| | --- | | RECHERCHIERTE SACHGEBIETE (Int. Cl.4) |
| A | EP-A-0 058 645 (SELENIA INDUSTRIE ELETTRONICHE ASSOCIATE S.p.A.)<br>* Seite 4, Zeile 15 - Seite 6, Zeile 30; Anspruch 1; Abbildungen 1-3 * | 1 | H 01 L<br>G 01 J |
| | ---     -/- | | |

Der vorliegende Recherchenbericht wurde für alle Patentansprüche erstellt.

| Recherchenort<br>DEN HAAG | Abschlußdatum der Recherche<br>11-02-1986 | Prüfer<br>VISENTIN A. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | DE-A-2 211 699 (SENSONS INC.)<br><br>* Seite 1, Zeile 1 - Seite 2, Zeile 12; Seite 3, zeile 31 - Seite 4, Zeile 17; Seite 8, Zeile 31 - Seite 9, Zeile 14; Seite 12, Zeile 21 - Seite 13, Zeile 6; Ansprüche 1,4,12,14; Abbildungen 4,5,11 *<br><br>----- | 1,3,4, 6 | |
| | | | **RECHERCHIERTE SACHGEBIETE (Int. Cl.4)** |

Der vorliegende Recherchenbericht wurde für alle Patentansprüche erstellt

| Recherchenort<br>DEN HAAG | Abschlußdatum der Recherche<br>11-02-1986 | Prüfer<br>VISENTIN A. |
|---|---|---|